**Europäisches Patentamt**

**European Patent Office**

**Office européen des brevets**

(11) Veröffentlichungsnummer: **0 481 337 A1**

# EUROPÄISCHE PATENTANMELDUNG

(21) Anmeldenummer: **91117168.4**

(22) Anmeldetag: **09.10.91**

(51) Int. Cl.5: **C04B 35/00**, C04B 35/60, H01L 39/24

(30) Priorität: **13.10.90 DE 4032539**
**22.03.91 DE 4109499**

(43) Veröffentlichungstag der Anmeldung:
**22.04.92 Patentblatt 92/17**

(84) Benannte Vertragsstaaten:
**AT BE CH DE DK ES FR GB GR IT LI LU NL SE**

(71) Anmelder: **HOECHST AKTIENGESELLSCHAFT**
**Postfach 80 03 20**
**W-6230 Frankfurt am Main 80(DE)**

(72) Erfinder: **Lang, Christoph, Dr.**
**Milseburgstrasse 7**
**W-6000 Frankfurt am Main(DE)**
Erfinder: **Hettich, Bernhard, Dr.**
**Im Hirtengraben 8**
**W-6239 Eppstein/Taunus(DE)**
Erfinder: **Schwarz, Martin, Dr.**
**Loreleistrasse 7**
**W-6230 Frankfurt am Main 80(DE)**
Erfinder: **Bestgen, Harro, Dr.**
**Hattersheimer Strasse 14**
**W-6233 Kelkheim (Taunus)(DE)**
Erfinder: **Elschner, Steffen, Dr.**
**Holbeinstrasse 5d**
**W-6272 Niedernhausen(DE)**
Erfinder: **Volz, Stefanie**
**Kohlhäuser Strasse 9**
**W-6366 Wölfersheim-Berstadt(DE)**
Erfinder: **Küllmer, Iris**
**Hostatostrasse 33**
**W-6230 Frankfurt am Main(DE)**

(54) **Supraleitende Verbindung und Verfahren zu ihrer Herstellung.**

(57) Beschrieben wird eine schwarze supraleitende Masse der Bruttozusammensetzung $Bi_4 (Sr, Ca)_y Cu_z O_\delta$, wobei $z = 2$-3, $y = 4$-6 und Sr/Ca 1:1 bis 10:1 ist. Sie enthält mindestens 10 Gew.-% einer supraleitenden Phase der allgemeinen Formel $Bi_{4+x}(Sr, Ca)_{5-x}Cu_3O_{4+\delta}$, wobei x zwischen 0 und 0.7, insbesondere 0.1 und 0.4, liegt, mit einer kristallographischen Elementarzelle der Abmessungen $a = 5,4 \cdot 10^{-8}$ cm, $b = 5,39 \cdot 10^{-8}$ cm, $c = 27,4 \cdot 10^{-8}$ cm und einem Atomverhältnis Sr/Ca von 1:1 bis 10:1. Die Sprungtemperatur für die Supraleitung beträgt mindestens 80K. Zur Herstellung der Masse werden Oxide von Bi, Sr, Ca, und Cu in Molverhältnissen, die der Bruttozusammensetzung entsprechen, aufgeschmolzen, die Schmelze erstarren gelassen, die erstarrte Schmelze bei einer Temperatur von mindestens 750° C, aber unterhalb des Schmelzpunktes von ca. 880° C in einer Atmosphäre, die 5 bis 15 Vol.-% $O_2$, enthält, getempert und dann auf Raumtemperatur abgekühlt.

Fig. 1

Die vorliegende Erfindung betrifft die Herstellung einer schwarzen kristallinen Masse, die Wismut, Strontium, Kalzium und Kupfer in oxidischer Form enthält und einen neuen Supraleiter mit einer Sprungtemperatur von mindestens 80 K enthält.

In der Gruppe der supraleitenden oxidkeramischen Verbindungen, die aus den Metallen Wismut, Strontium, Kalzium und Kupfer gebildet werden, sind im wesentlichen drei Vertreter bekannt und hinreichend untersucht worden. Dies sind die Verbindungen $Bi_2Sr_2Ca_2Cu_3O_{12-x}$, bekannt als "3-Schicht-Verbindung" mit einer Sprungtemperatur von 110 K (H. Maeda et al. Japan, J. Appl. Phys. 27 (1988) L209) die Verbindung $Bi_2Sr_2CaCu_2O_{10-\delta}$ - ("2-Schicht-Verbindung") mit einer Sprungtemperatur von 92 K (vgl. z.B. M.A. Subramanian et al., Science 239, 1988, Seite 1015) und die Verbindung $Bi_2(Sr,Ca)_2CuO_{8-\delta}$ ("1-Schicht-Verbindung") mit einer Sprungtemperatur von ca. 75 K (vgl. z.B. von Schnering et al., Angewandte Chemie, Band 100, 1988, S. 604).

Für Anwendungen oberhalb der Temperatur des flüssigen Stickstoffs kamen bisher nur die beiden erstgenannten Verbindungen in Frage. Andererseits stehen einer breiten kurzfristigen Anwendung dieser Verbindungen mehrere ungünstige Eigenschaften im Wege. So ist es bisher nicht gelungen, phasenreines Material der 3-Schicht-Verbindung mit hoher Dichte zu erzeugen. Die Herstellung der 2-Schicht-Verbindung ist in hohen Dichten nur über eine Schmelzsynthese bei sehr hohen Temperaturen möglich (ca. 1100°C), vgl. J. Bock und E. Preissler, Proceedings of MRS Conference 1989, Spring Meeting San Diego, April 1989.

Es bestand also die Aufgabe, weitere Materialien mit einer Sprungtemperatur oberhalb der Temperatur des flüssigen Stickstoffs (77 K) bereitzustellen, die sich bei vergleichsweise niedriger Temperatur in hoher Dichte gewinnen lassen.

Es wurde nun ein Verfahren zur Herstellung einer aus den Oxiden von Wismut, Strontium, Kalzium und Kupfer zusammengesetzten Masse gefunden, die eine neue supraleitende Phase mit einer Sprungtemperatur von mindestens 80 K enthält. Das Verfahren ist dadurch gekennzeichnet, daß man ein Gemisch der Oxide mit einer Bruttozusammensetzung von $Bi_4(Sr,Ca)_yCu_zO_d$ bereitet, in der y = 4 bis 6, z = 2 bis 3, und das Atomverhältnis Sr/Ca = 1:1 bis 10:1 beträgt, man das Gemisch bis zur Schmelze aufheizt, man die Schmelze erstarren läßt, man die erstarrte Schmelze bei einer Temperatur von mindestens 750°C aber unterhalb des Schmelzpunktes in eine Atmosphäre tempert, die 5 bis 15 Volumen-% Sauerstoff, Rest Inertgas, enthält, und dann auf Raumtemperatur abkühlt. Dabei fällt eine schwarze kristalline Masse an.

Auf die Wertigkeit der Oxide kommt es kaum an. Beispielsweise sind $Bi_2O_3$ und $Bi_2O_4$, $Cu_2O$ und $CuO$ einsetzbar. Der Index d errechnet sich aus dem Sauerstoffgehalt der eingesetzten Oxide.

Bevorzugt ist eine Atmosphäre mit einem Volumenanteil von 8 bis 12 %, $O_2$ insbesondere 9 bis 11 %. Das Inertgas ist vorzugsweise aber ein Edelgas wie Argon.

Die Bruttozusammensetzung der schwarzen supraleitenden Masse entspricht (bis auf den Sauerstoffgehalt) dem der Ausgangsmischung. Die schwarze supraleitende Masse besitzt die Bruttozusammensetzung $Bi_4(Sr,Ca)_yCu_zO_d$, wobei z = 2-3, y = 4-6 und Sr/Ca = 1:1 bis 10:1.

Die in der erhaltenen schwarzen Masse vorhandene neue supraleitende Phase weist die allgemeine Formel $Bi_{4+x}(Sr,Ca)_{5-x}Cu_3O_e$, wobei x zwischen 0 und 0,6, insbesondere 0,3 und 0,5 liegt, eine kristallographische Elementarzelle der Abmessungen a = 5,4 Å, b = 5,39 Å, c° = 27,4 Å, ein Atomverhältnis Sr/Ca von 1:1 bis 10:1, insbesondere 2:1 bis 4:1, und eine Sprungtemperatur für die Supraleitung von mindestens 80 K auf. Der Index e für den Sauerstoffgehalt liegt wahrscheinlich zwischen 14 und 16.

Die neue supraleitende Phase ist dadurch gekennzeichnet, daß in ihr im wesentlichen alternierende Schichten mit Abständen von etwa 12 Å (= 1,2 nm) und etwa 15 Å (= 1,5 nm) vorliegen. Mindestens 75 % aller Doppelschicht-Abstände betragen 27,4 Å (= 2,74 nm). Das Zahlenverhältnis der Einzelschichten mit Schichtabstand 1,5 nm zu Einzelschichten mit Schichtabstand 1,2 nm liegt im Bereich von 0,95 bis 1,05.

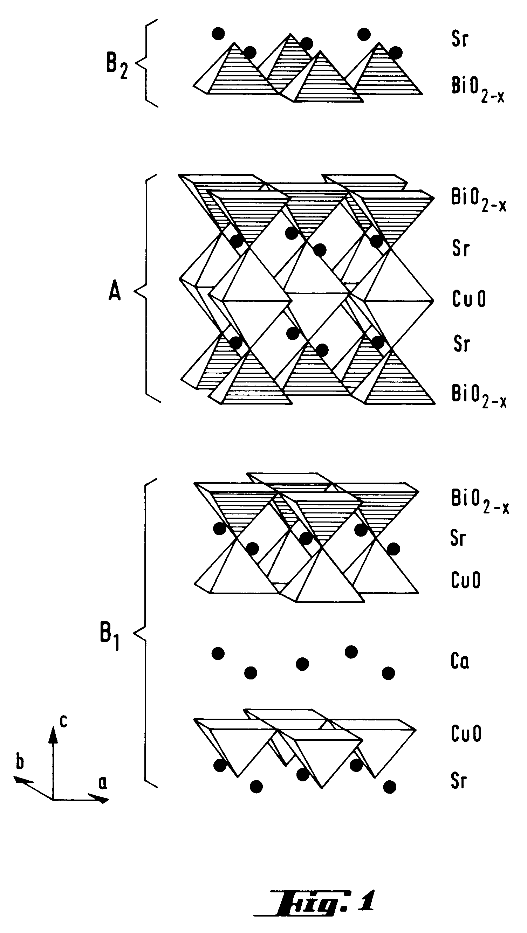

In Fig. 1 ist die Struktur der neuen Phase für die idealisierte Zusammensetzung $Bi_4Sr_4CaCu_3O_{14+x}$ (d.h. Sr:Ca = 4:1) dargestellt. die Region A weist Strukturelemente der 1-Schicht-Verbindung auf. Die Regionen $B_1$ + $B_2$ zusammen bilden eine Schicht (B) der 2- Schicht-Verbindung. A und B sind alternierend angeordnet.

Da in der Elementarzelle a etwa b entspricht, liegt eine näherungsweise tetragonale Metrik vor. Wahrscheinlich ist die kristallographische Elementarzelle orthorhombisch wie bei den anderen oxidkeramischen Wismut enthaltenden Supraleitern, z.B. der 1-Schicht-Verbindung.

Ein besonders hoher Anteil an neuer supraleitender Phase von etwa 60 Gew.-% wird erhalten, wenn das Ausgangsgemisch der Bruttozusammensetzung $Bi_2Sr_{1,3}Ca_{0,7}CuO_{etwa\ 6}$ entspricht.

Man kann das aufzuschmelzende Oxidgemisch aus einem Ausgangsgemisch bereiten, das Oxidvorläufer enthält, d.h. Verbindungen, die beim Erhitzen in Oxide übergehen. Als Oxidvorläufer gelten beispielsweise die Carbonate, Nitrate, Hydroxide und Oxalate der genannten Metalle. Vorteilhafterweise wird dieses Ausgangsgemisch langsam aufgeheizt, da es zur Abspaltung von Gasen kommt, und anschließend mindestens 6 Stunden bei 700 bis 800°C bis zur Freisetzung der Oxide erhitzt. Beim Aufheizen auf mindestens 880°C soll sichergestellt sein, daß der gesamte Ansatz geschmolzen ist. Ein Erhitzen auf oberhalb 1000°C bringt keine Vorteile, da Kupferoxid dann zunehmend flüchtiger wird. Die Art des Abkühlens scheint keine große Bedeutung zu haben, da sowohl rasches Abkühlen durch Ausgießen auf eine kalte Unterlage wie langsames Abkühlen im Ofen zu vergleichbaren Ergebnissen führt. Die Dauer des Temperns bei Temperaturen zwischen 750°C und dem Schmelzpunkt der bei ca. 880°C liegt, beträgt vorzugsweise mindestens eine Stunde, insbesondere mindestens 4 Stunden, besonders bevorzugt mindestens 8 Stunden. Bei größeren Körpern dauert die (diffusionsbestimmte) Verteilung des Sauerstoffs länger.

Die neue supraleitende Phase kann - kristallographisch gesehen - als eine Kombination der kristallographischen Halbzelle der 1-Schicht-Verbindung mit der kristallographischen Halbzelle der 2-Schicht-Verbindung aufgefaßt werden (jeweils in Richtung der c-Achse gesehen). Aus TEM-Untersuchungen ist zu erkennen, daß die Länge der kleinsten wiederkehrenden Einheit in Richtung 001 etwa 2,7 nm beträgt. Dies entspricht der Summe von c/2 der 1-Schicht-Verbindung und c/2 der 2-Schicht-Verbindung. Diese Beobachtungen rechtfertigen die Bezeichnung der neuen Phase als der einer "1 1/2-Schicht-Verbindung".

An geschmolzenen und wieder erstarrten Proben, die noch nicht in Gegenwart von Sauerstoff nachbehandelt wurden und daher nicht supraleitend sind, läßt sich in TEM-Aufnahmen kein Hinweis auf das Vorliegen der neuen Verbindung finden. (TEM = hochauflösende Transmissionselektronenmikroskopie, vgl. Angew. Chemie 1988, 618).

Sowohl für das Tiegelmaterial beim Aufschmelzen des Ansatzes, die Unterlage für das Erstarren einer ausgegossenen Schmelze und das Gefäß, das beim Tempern verwendet wird, sollten chemisch inerte Materialien eingesetzt werden. Geeignete Tiegelmaterialien sind z.B. Silber, Magnesiumoxid, Strontiumtitanat, Kupfer, Zirkonoxid, Zinnoxid und Strontiumindat. In Tiegeln aus Aluminiumoxid bilden sich in der Schmelze Aluminate, die röntgenographisch als Verunreinigung nachweisbar sind. Die oberhalb 880°C vorliegende Schmelze ist dünnflüssig und läßt sich z.B. auf eine Kupfer oder ®Ceram-Platte problemlos vergießen. Vorzugsweise beträgt die Mindestverweildauer bei der Schmelztemperatur 10 Minuten.

Ansätze der Bruttozusammensetzung $Bi_4(Sr,Ca)_5Cu_3O_{etwa\ 14}$ zeigen (nach Weiterbehandlung) röntgenographisch Spuren der 2-Schicht-Verbindung neben der neuen Phase. Ansätze der Bruttozusammensetzung $Bi_2(Sr,Ca)_5CuO_{etwa\ 9}$ ergeben (nach Weiterbehandlung) die neue Phase verunreinigt mit der 1-Schicht-Verbindung.

Bei der Nachbehandlung in Gegenwart eines Gasgemisches mit geringem $O_2$-Gehalt (Rest: Inertgas) wird die neue supraleitende Verbindung/Phase gebildet und gleichzeitig der für die Supraleitung notwendige Sauerstoffgehalt eingestellt. Wenn die Nachbehandlung an Luft durchgeführt wird, so begünstigt dies die Bildung der 2-Schicht-Verbindung. Die neue 1 1/2-Schicht-Verbindung wird dann nicht beobachtet. In Abwesenheit von Sauerstoff, z.B. unter reinem Argon, bildet sich die neue Phase nicht. Unter reduziertem Sauerstoff-Partialdruck ($Ar/O_2$ = 9:1) bildet sich hauptsächlich die neue Phase ohne 2-Schicht-Verbindung. Neben der 1 1/2-Schicht- Verbindung ist nur noch die (bekannte) 1-Schicht-Verbindung nachweisbar.

Die neue Phase weist etwa die gleiche Stromtragfähigkeit und Sprungtemperatur wie die bekannte 2-Schicht-Verbindung auf. Bei ihrer Herstellung ist jedoch eine niedrigere Schmelztemperatur erforderlich.

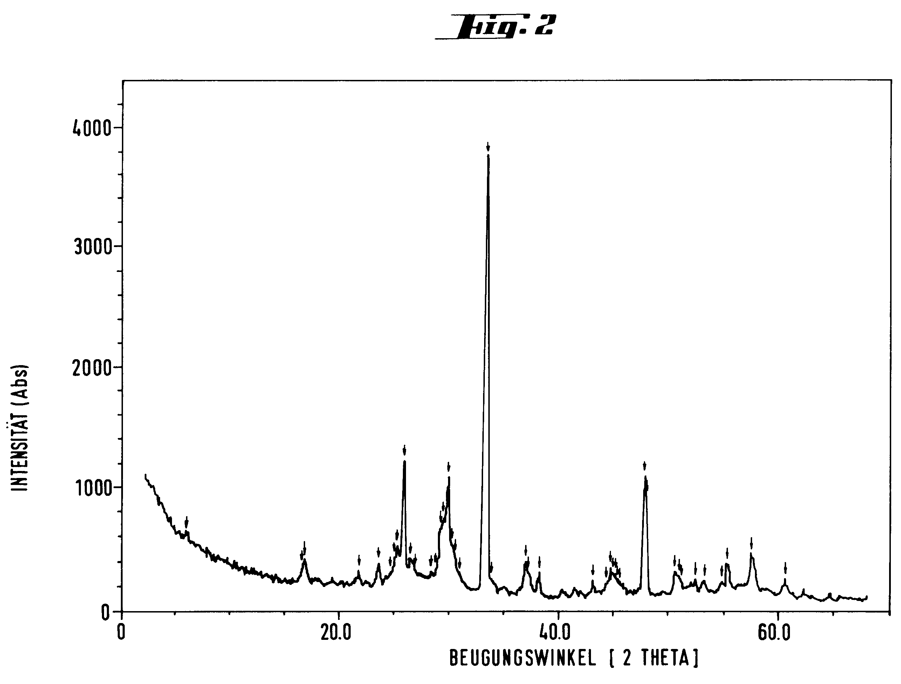

Die Kristallinität der Schmelzreguli (erstarrten Schmelzen) wird durch höhere Reaktionstemperatur und längere Dauer begünstigt. Die 1-Schicht-Verbindung ist immer nachweisbar. Das Auftreten von Anteilen der neuen Phase ist an einer Intensitätsänderung und peak-Verbreiterung des Röntgenbeugungsdiagramms zu erkennen. Dies zeigt Figur 2.

Das Abkühlen der getemperten Probe erfolgt vorteilhafterweise langsam insbesondere in einer Geschwindigkeit von maximal 100 K/h auf Raumtemperatur.

Die Erfindung wird durch die Beispiele näher erläutert.

Beispiel 1

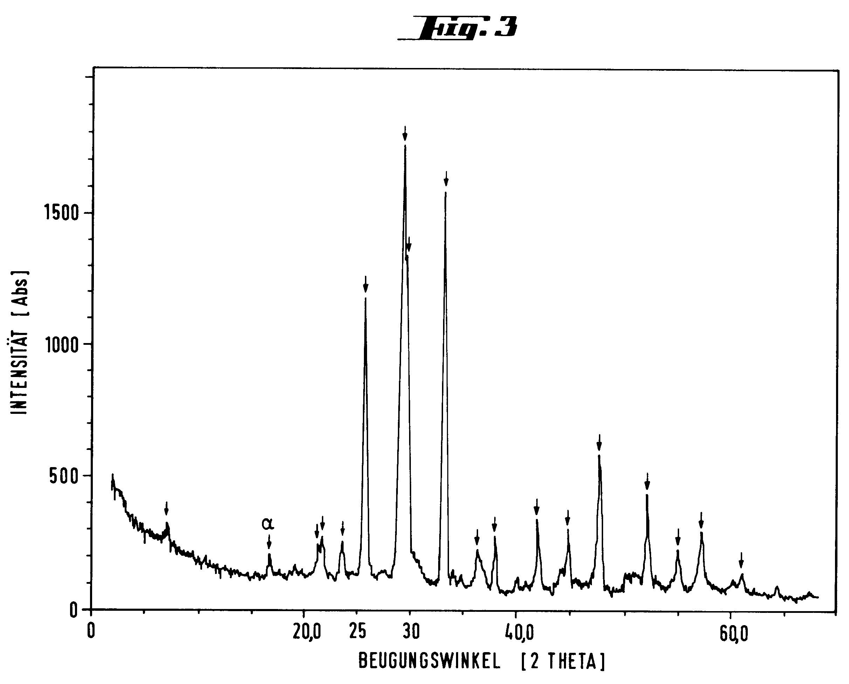

Eine Mischung aus $Bi_2O_3$, $SrCO_3$, CaO und CuO wird im Metallverhältnis $Bi_2Sr_{1,3}Ca_{0,7}CuO$ eingewogen und innig in einem Achatmörser vermischt. Das Pulver wird in einem Gemisch $Ar:O_2$ von 9:1 während 4h von Raumtemperatur auf 900°C erhitzt, dort 20 min. gehalten, dann aus dem Ofen genommen und in einen Kupferblock mit Vertiefung gegossen. Die röntgenographische Untersuchung zeigt das ausschließliche Vorliegen der Einschichtverbindung (Figur 3). Eine Squidmessung zeigt schwachen Paramagnetismus.

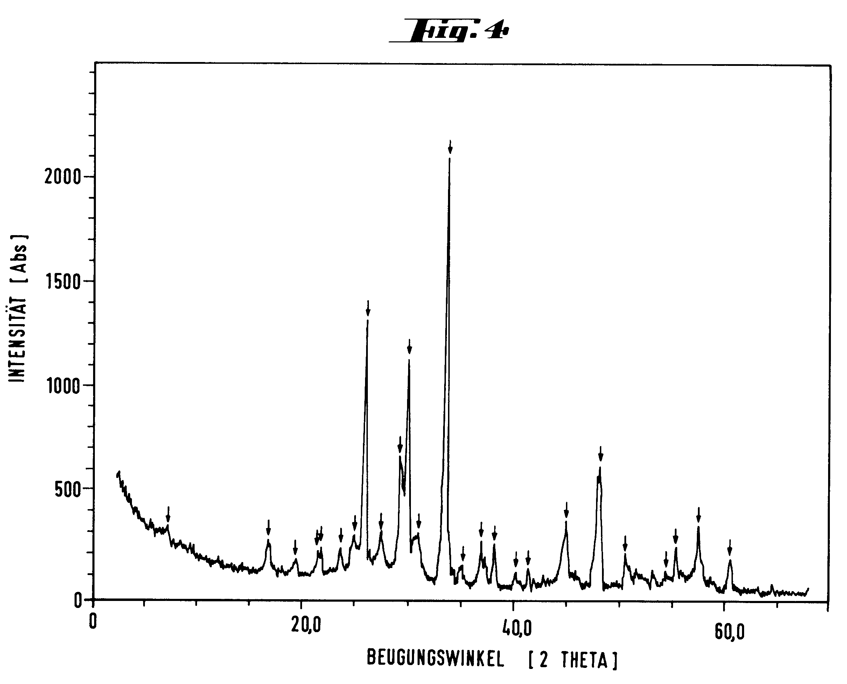

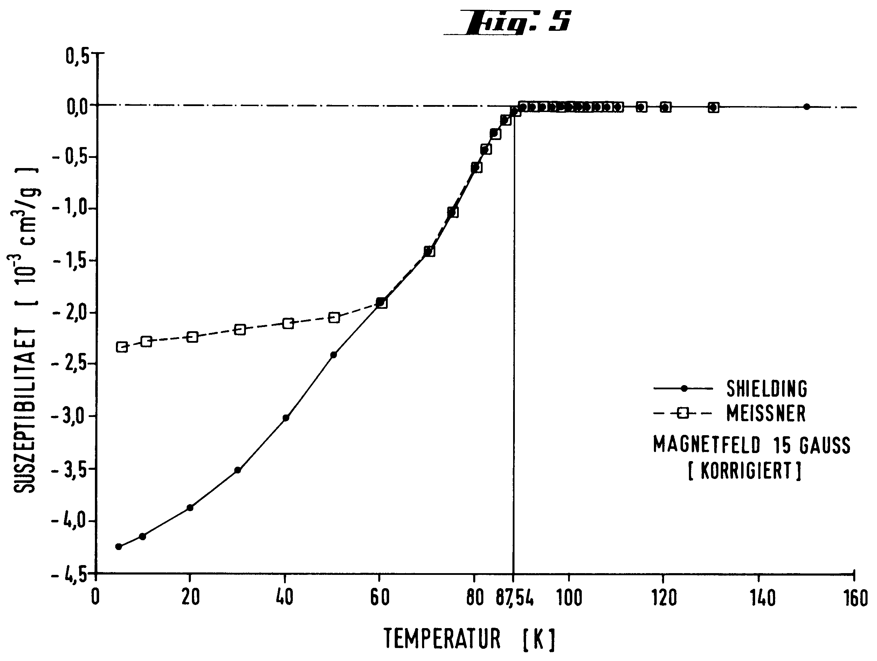

Der erstarrte Schmelzregulus wird in demselben Gasgemisch in 4h auf 820°C aufgeheizt, bei dieser Temperatur 12h lang gehalten, in 4h auf 600°C abgekühlt und dann dem Ofen entnommen. Das Röntgenbeugungsdiagramm (Figur 4) zeigt weiterhin charakteristische Reflexe der 1-Schicht-Verbindung; das Intensitätsverhältnis und die Peakform ändern sich jedoch signifikant. Die magnetische Messung (Squid) zeigt eine Sprungtemperatur von 88 K, der supraleitende Volumenanteil (Meissner-Effekt) beträgt fast 20 % (Figur 5).

Beispiel 2

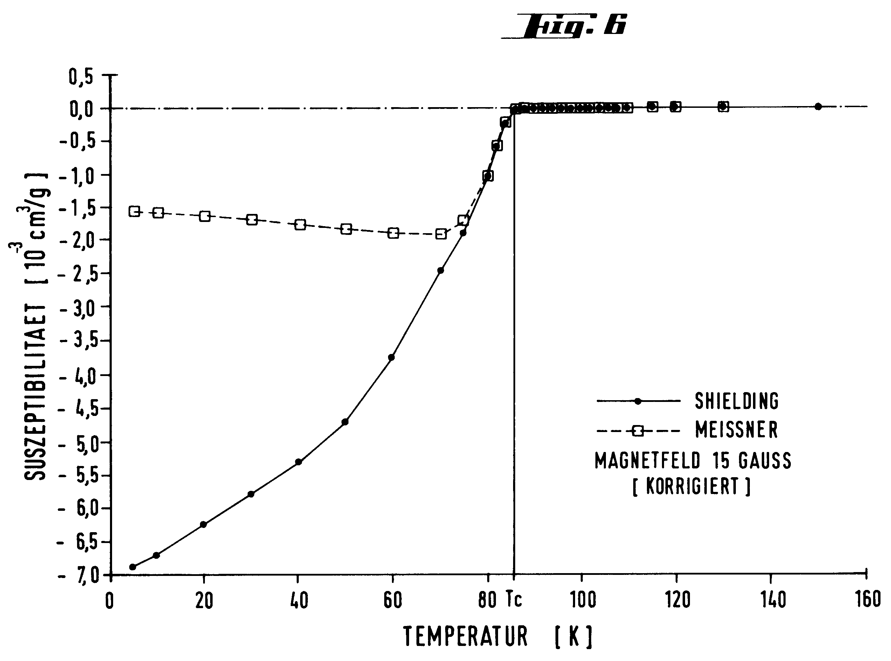

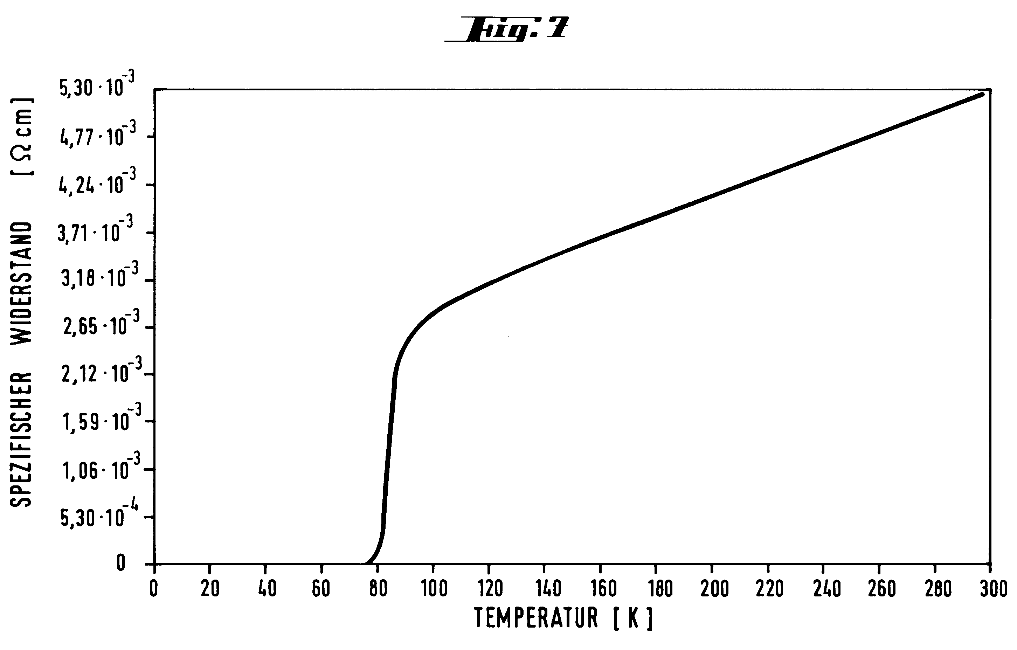

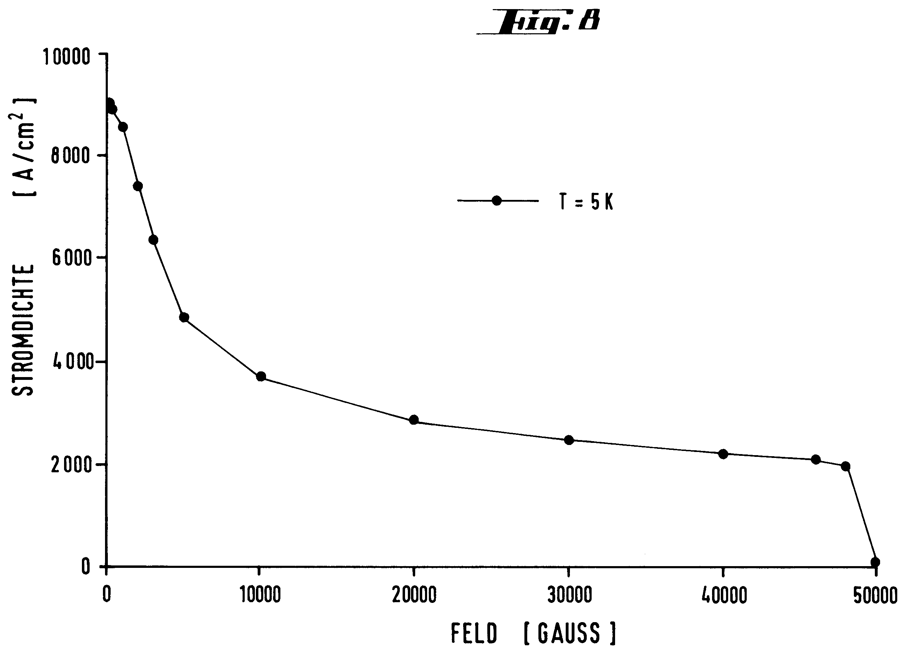

Eine analog Beispiel 1, jedoch in Luftatmosphäre dargestellte Probe (Schmelzregulus) wird wiederum unter einem Ar:O$_2$ Gasgemisch im Verhältnis 9:1 thermisch nachbehandelt. Nach dem Aufheizen in 4h auf 820°C wird weitere 4h bei dieser Temperatur gehalten und dann innerhalb von 20h auf Raumtemperatur abgekühlt. Die Squidmessung dieser Probe zeigt 17 % Meissner-Anteil (Figur 6). Die Sprungtemperatur Tc beträgt 86K (Leitfähigkeitsmessung siehe Figur 7). Bei 78K ist kein Widerstand in der Probe mehr zu beobachten. Die Probe trägt einen kritischen Strom von ca. 9000 A/cm$^2$ bei 4K/0 Gauss. Die Abhängigkeit der kritischen Stromdichte von einem außen angelegten Magnetfeld ist in Figur 8 gezeigt.

Beispiel 3

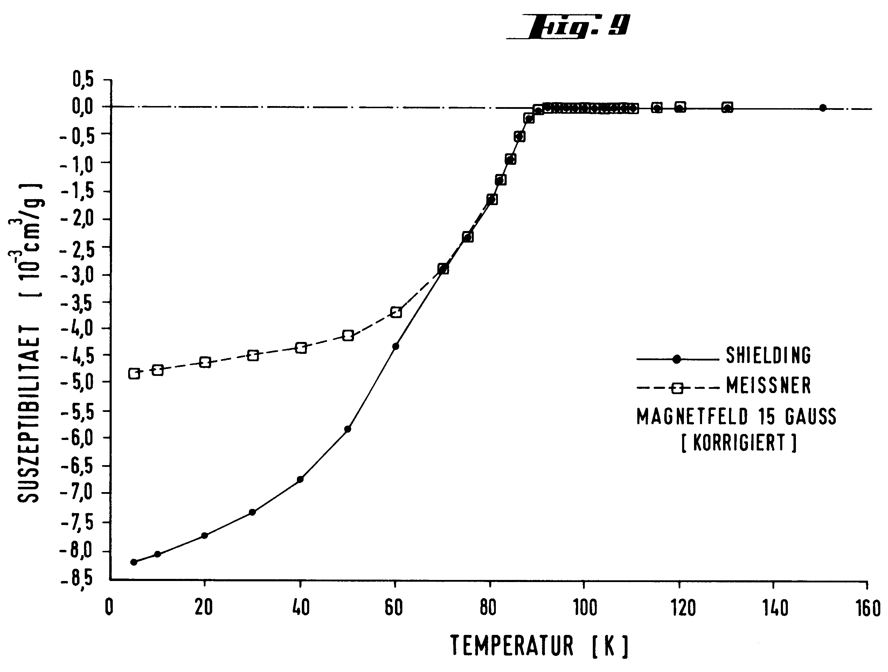

Eine Ausgangsmischung wie in Beispiel 1 wird an Luftatmosphäre in 1h auf 900°C erhitzt, bei dieser Temperatur 5 min gehalten und dann in 40h auf 700°C abgekühlt. Die Nachbehandlung unter dem in Beispiel 1 erwähnten Gasgemisch führt zu einem Produkt mit einer Sprungtemperatur von 90K und einem Meissneranteil von 40 %. Das Ergebnis der Squidmessung zeigt Figur 9.

Beispiel 4

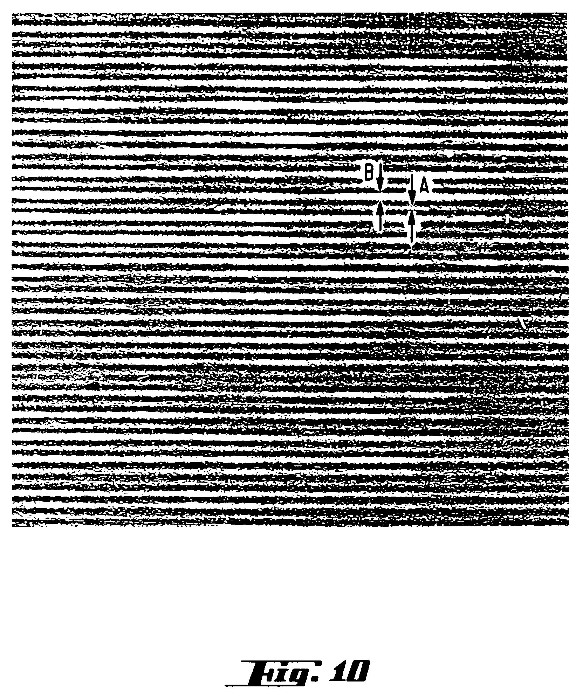

Eine ebenso dargestellte Probe, die vor dem Nachtemperschritt in nur 4h auf 700°C abgekühlt wurde, zeigt nach dem Nachtempern ein identisches Röntgendiffraktogram und 16 % Meissneranteil bei einem Tc von 88K (Squidmessung). STEM-Aufnahmen dieser Probe zeigen das Vorliegen von Bereichen der 1-Schicht-Verbindung neben großen Bereichen der neuen Phase (Fig. 10). Andere Phasen wurden auch mit diesem Verfahren nicht entdeckt. Es werden nur Bi-Atome abgebildet. Gegenüberliegende Schichten (z.B. BiO$_2$ der Region B$_2$ und BiO$_2$ der benachbarten Region A in Fig. 1) sind nicht aufgelöst, sie erscheinen als ein schwarzer Strich. Der weiße Bereich zwischen zwei eng benachbarten Linien entspricht der Region A in Fig. 1, der weiße Bereich zwischen zwei weiter entfernten Linien entspricht Schicht B in Fig. 1.

Beispiel 5

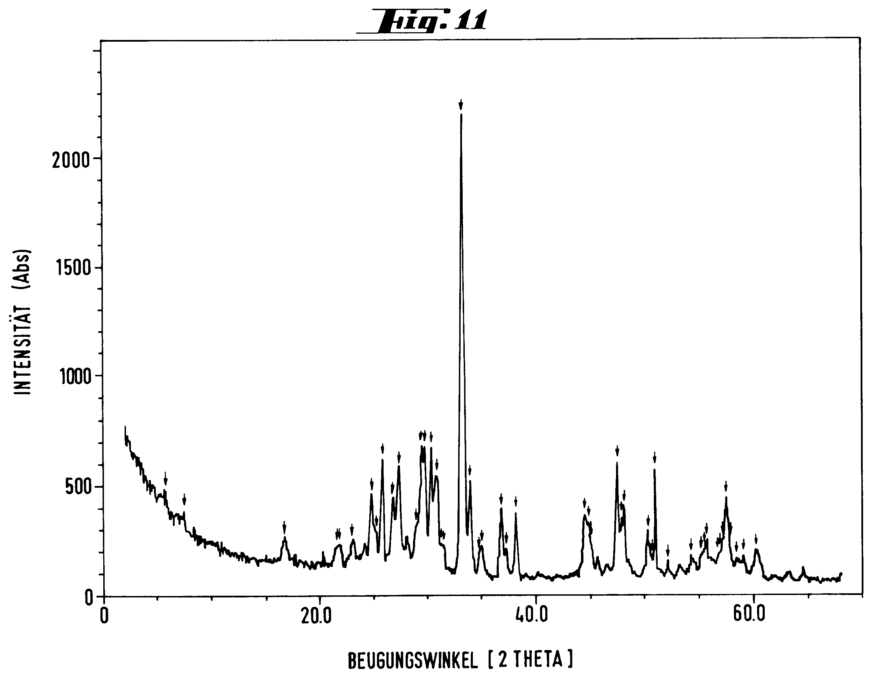

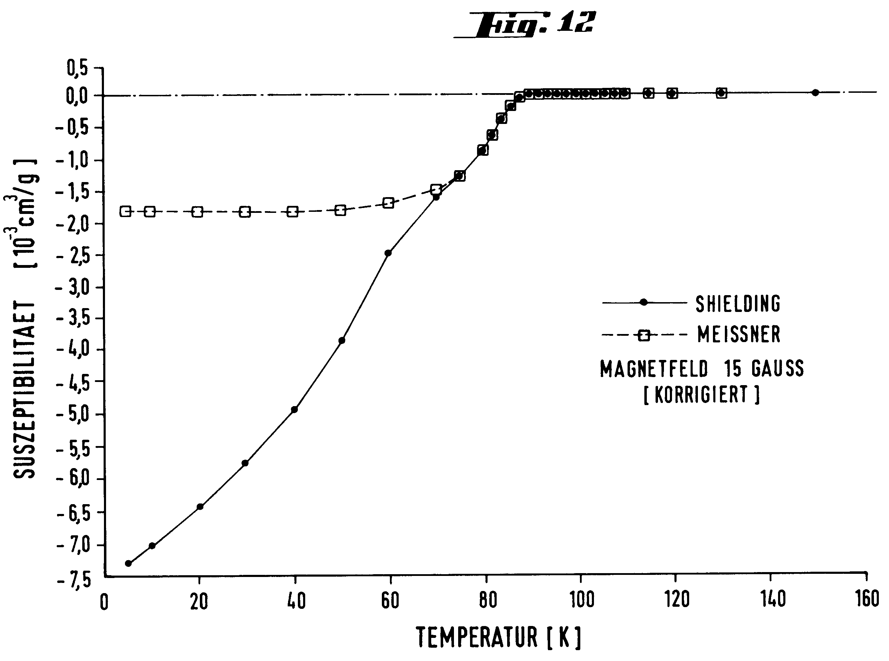

Die im Beispiel 1 erwähnten Ausgangsverbindungen wurden im Brutto-Verhältnis Bi$_4$Sr$_3$Ca$_2$Cu$_3$O$_{14}$ gemischt, gemörsert und wie in Beispiel 1 aufgeschmolzen. Die Nachbehandlung Ar:O$_2$ war folgende: In 1h Aufheizen auf 820°C, bei dieser Temperatur 12h halten und dann in 6h Abkühlen auf Raumtemperatur. Röntgenographisch ist neben der Hauptphase 1-Schicht-Verbindung auch ein kleinerer Anteil 2-Schicht-Verbindung nachweisbar (Figur 11). Die Squidmessung zeigt ein Tc von 87K, einen Meissner-Anteil von 20 % und einen Shielding-Anteil von 65 % (Figur 12).

**Patentansprüche**

1. Schwarze supraleitende Masse der Bruttozusammensetzung Bi$_4$(Sr,Ca)$_y$Cu$_z$O$_d$ wobei z = 2-3, y = 4-6 und Sr/Ca 1:1 bis 10:1 ist, enthaltend mindestens 10 Gew.-% einer supraleitenden Phase der allgemeinen Formel Bi$_{4+x}$(Sr,Ca)$_{5-x}$Cu$_3$O$_{14+\alpha}$, wobei x zwischen 0 und 0.6, insbesondere 0.1 und 0.4 liegt, mit einer kristallographischen Elementarzelle der Abmessungen a = 5.4Å, b = 5.39Å, c = 27.4Å, einem Atomverhältnis Sr/Ca von 1:1 bis 10:1 und einer Sprungtemperatur für die Supraleitung von mindestens 80K.

2. Schwarze supraleitende Verbindung der allgemeinen Formel Bi$_{4+x}$(Sr,Ca)$_{5-x}$Cu$_3$O$_{14+\delta}$, wobei x zwischen 0 und 0.7, insbesondere 0.1 und 0.4 liegt, mit einer kristallographischen Elementarzelle der Abmessungen a = 5.4Å, b = 5.39Å, c = 27.4Å und einem Atomverhältnis Sr/Ca von 1:1 bis 10:1, insbesondere 2:1 - 4:1, und einer Sprungtemperatur für die Supraleitung von mindestens 80K.

3. Verbindung gemäß Anspruch 2, dadurch gekennzeichnet, daß in ihr im wesentlichen alternierende Schichten mit Abständen von 12Å und 15Å vorliegen.

4. Verfahren zur Herstellung der supraleitenden Masse gemäß Anspruch 1 durch Erhitzen der Oxide von Bi, Sr, Ca und Cu und nachfolgender Behandlung mit Sauerstoff, dadurch gekennzeichnet, daß man Oxidgemische mit einer Bruttozusammensetzung entsprechend Bi$_4$(Sr,Ca)$_y$Cu$_z$O$_d$, wobei y = 4-6, z = 2-3 und Sr/Ca = 1:1 bis 10:1 ist, aufschmilzt, man die Schmelze erstarren läßt, man die erstarrte Schmelze bei einer Temperatur von mindestens 750°C, aber unterhalb des Schmelzpunktes von ca. 880°C in einer Atmosphäre, die 5 bis 15 Vol.-% O$_2$, insbesondere 9-12 Vol.-% O$_2$, Rest Inertgas, enthält, mindestens 1 Stunde hält und dann auf Raumtemperatur abkühlt.

**5.** Verfahren nach Anspruch 4, dadurch gekennzeichnet, daß man mindestens 4h auf eine Temperatur von mindestens 750°C erhitzt.

**6.** Verfahren nach Anspruch 4, dadurch gekennzeichnet, daß man nach dem Erhitzen in Inertgas mit einer Geschwindigkeit von maximal 100 K/h auf Raumtemperatur abkühlt.

**7.** Verfahren nach Anspruch 4, dadurch gekennzeichnet, daß man durch Erhitzen das Oxidgemisch aus einem Ausgangsgemisch bereitet, das mindestens eine Verbindung enthält, die beim Erhitzen in ein Oxid übergeht.

**8.** Verfahren nach Anspruch 7, dadurch gekennzeichnet, daß man das Ausgangsgemisch während mindestens 6h bei 700-800°C erhitzt.

**9.** Verfahren nach Anspruch 8, dadurch gekennzeichnet, daß man das Ausgangsgemisch mit einer Geschwindigkeit von maximal 100 K/h von Raumtemperatur auf 700-800°C erhitzt.

**Patentansprüche für folgende Vertragsstaaten : ES, GR**

**1.** Verfahren zur Herstellung einer schwarzen, supraleitenden Masse der Bruttozusammensetzung $Bi_4(Sr,Ca)_yCu_zO_d$ wobei $z = 2\text{-}3$, $y = 4\text{-}6$ und Sr/Ca 1:1 bis 10:1 ist, durch Erhitzen der Oxide von Bi, Sr, Ca und Cu und nachfolgender Behandlung mit Sauerstoff, dadurch gekennzeichnet, daß man Oxidgemische mit einer Bruttozusammensetzung entsprechend $Bi_4(Sr,Ca)_yCu_zO_d$, wobei $y = 4\text{-}6$, $z = 2\text{-}3$ und Sr/Ca $= 1:1$ bis 10:1 ist, aufschmilzt, man die Schmelze erstarren läßt, man die erstarrte Schmelze bei einer Temperatur von mindestens 750°C, aber unterhalb des Schmelzpunktes von ca. 880°C in einer Atmosphäre, die 5 bis 15 Vol.-% $O_2$, insbesondere 9-12 Vol.-% $O_2$, Rest Inertgas, enthält, mindestens 1 Stunde hält und dann auf Raumtemperatur abkühlt.

**2.** Verfahren nach Anspruch 1, dadurch gekennzeichnet, daß man mindestens 4h auf eine Temperatur von mindestens 750°C erhitzt.

**3.** Verfahren nach Anspruch 1, dadurch gekennzeichnet, daß man nach dem Erhitzen in Inertgas mit einer Geschwindigkeit von maximal 100 K/h auf Raumtemperatur abkühlt.

**4.** Verfahren nach Anspruch 1, dadurch gekennzeichnet, daß man durch Erhitzen das Oxidgemisch aus einem Ausgangsgemisch bereitet, das mindestens eine Verbindung enthält, die beim Erhitzen in ein Oxid übergeht.

**5.** Verfahren nach Anspruch 4, dadurch gekennzeichnet, daß man das Ausgangsgemisch während mindestens 6h bei 700-800°C erhitzt.

**6.** Verfahren nach Anspruch 5, dadurch gekennzeichnet, daß man das Ausgangsgemisch mit einer Geschwindigkeit von maximal 100 K/h von Raumtemperatur auf 700-800°C erhitzt.

**_Fig. 1_**

_Fig. 2_

EP 0 481 337 A1

Fig: 3

EP 0 481 337 A1

# Fig. 4

INTENSITÄT [ Abs ]

BEUGUNGSWINKEL [ 2 THETA ]

Fig. 5

SUSZEPTIBILITAET [ $10^{-3}$ cm$^3$/g ]

TEMPERATUR [K]

●——— SHIELDING
–□– MEISSNER

MAGNETFELD 15 GAUSS
[ KORRIGIERT ]

EP 0 481 337 A1

**Fig. 6**

SUSZEPTIBILITAET [ $10^{-3}$ cm³/g ]

TEMPERATUR [K]

SHIELDING
MEISSNER
MAGNETFELD 15 GAUSS
[ KORRIGIERT ]

# Fig. 7

SPEZIFISCHER WIDERSTAND [ Ω cm ]

$5,30 \cdot 10^{-3}$
$4,77 \cdot 10^{-3}$
$4,24 \cdot 10^{-3}$
$3,71 \cdot 10^{-3}$
$3,18 \cdot 10^{-3}$
$2,65 \cdot 10^{-3}$
$2,12 \cdot 10^{-3}$
$1,59 \cdot 10^{-3}$
$1,06 \cdot 10^{-3}$
$5,30 \cdot 10^{-4}$
$0$

TEMPERATUR [ K ]

EP 0 481 337 A1

*Fig. 8*

STROMDICHTE [ A/cm² ]

FELD [ GAUSS ]

T = 5 K

EP 0 481 337 A1

*Fig. 9*

EP 0 481 337 A1

**Fig. 10**

_Fig. 11_

EP 0 481 337 A1

*Fig. 12*

EP 0 481 337 A1

Europäisches
Patentamt

Nummer der Anmeldung

EP    91 11 7168

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EPO 308 892 (FURUKAWA ELECTRIC CO.,LTD.) 29. März 1989 <br> * Beispiel 1 * <br> --- | 1-9 | C04B35/00 <br> C04B35/60 <br> H01L39/24 |
| A | EPO 362 492 (HOECHST AG) 11. April 1990 <br> * Beispiele 1-2 * <br> --- | 1-9 | |
| A | EPO 327 044 (HOECHST AG) 9. August 1989 <br> * Ansprüche 1-40 * <br> --- | 1-9 | |
| A | WO9 007 475 (HOECHST AG) 12. Juli 1990 <br> * Ansprüche 1-7 * <br><br> ----- | 1-9 | |
| | | | **RECHERCHIERTE SACHGEBIETE (Int. Cl.5)** <br><br> C04B <br> H01L |

Der vorliegende Recherchenbericht wurde für alle Patentansprüche erstellt

| Recherchenort | Abschlußdatum der Recherche | Prüfer |
|---|---|---|
| DEN HAAG | 10 JANUAR 1992 | LUETHE H. |

EPO FORM 1503 03.82 (P0403)